# EUROPEAN PATENT APPLICATION

(11) **EP 1 732 148 A1**
(43) Date of publication of application: **13.12.2006**
(21) Application number: 06009997.5
(22) Date of filing: 15.05.2006
(51) Int. Cl.: H01L 45/00, H01L 27/24, G11C 16/02

(54) **Phase change memory cell having ring contacts**

(30) Priority: 07.06.2005 US 146509
(71) Applicant: Infineon Technologies AG, 81669 München (DE)
(72) Inventor: Happ, Thomas, Dr., Tarrytown NY 10591 (US)
(74) Representative: Jehle, Volker Armin

(57) **Abstract**

A memory cell includes a first ring contact (120a), a second ring contact (118a), and phase-change material (116a) contacting the first ring contact and the second ring contact.

## Description

### Background

Phase-change memories include phase-change materials that exhibit at least two different states. Phase-change material may be used in memory cells to store bits of data. The states of phase-change material may be referenced to as amorphous and crystalline states. The states may be distinguished because the amorphous state generally exhibits higher resistivity than does the crystalline state. Generally, the amorphous state involves a more disordered atomic structure, while the crystalline state is an ordered lattice. Some phase-change materials exhibit two crystalline states, e.g. a face-centered cubic (FCC) state and a hexagonal closest packing (HCP) state. These two crystalline states have different resistivities and may be used to store bits of data. In the following description, the amorphous state generally refers to the state having the higher resistivity, and the crystalline state generally refers to the state having the lower resistivity.

Phase change in the phase-change materials may be induced reversibly. In this way, the memory may change from the amorphous state to the crystalline state, and from the crystalline state to the amorphous state, in response to temperature changes. The temperature changes to the phase-change material may be achieved in a variety of ways. For example, a laser can be directed to the phase-change material, current may be driven through the phase-change material, or current can be fed through a resistive heater adjacent the phase-change material. With any of these methods, controllable heating of the phase-change material causes controllable phase change within the phase-change material.

When a phase-change memory comprises a memory array having a plurality of memory cells that are made of phase-change material, the memory may be programmed to store data utilizing the memory states of the phase-change material. One way to read and write data in such a phase-change memory device is to control a current and/or a voltage pulse that is applied to the phase-change material. The level of current and voltage generally corresponds to the temperature induced within the phase-change material in each memory cell. To minimize the amount of power that is used in each memory cell, the cross-section of the electrical contact for the phase-change material of the memory cell should be minimized.

### Summary

One embodiment of the present invention provides a memory cell. The memory cell includes a first ring contact, a second ring contact, and phase-change material contacting the first ring contact and the second ring contact.

### Brief Description of the Drawings

Embodiments of the invention are better understood with reference to the following drawings. The elements of the drawings are not necessarily to scale relative to each other. Like reference numerals designate corresponding similar parts.
Figure 1 is a block diagram illustrating one embodiment of a memory cell device.
Figure 2 illustrates a cross-sectional view of one embodiment of a phase-change memory cell.
Figure 3 illustrates a top cross-sectional view one embodiment of a portion of the phase-change memory cell.
Figure 4 illustrates a cross-sectional view of another embodiment of a phase-change memory cell.
Figure 5 illustrates a cross-sectional view of another embodiment of a phase-change memory cell.
Figure 6 illustrates a cross-sectional view of another embodiment of a phase-change memory cell.
Figure 7 illustrates a cross-sectional view of another embodiment of a phase-change memory cell.
Figure 8 illustrates a cross-sectional view of one embodiment of a preprocessed wafer.
Figure 9 illustrates a cross-sectional view of one embodiment of the preprocessed wafer and an electrode stack including a first contact material layer, a first insulation material layer, a second contact material layer, and a second insulation material layer.
Figure 10 illustrates a cross-sectional view of one embodiment of the preprocessed wafer and electrode stack after etching the electrode stack to form a memory cell location.
Figure 11 illustrates a cross-sectional view of one embodiment of the preprocessed wafer and electrode stack after depositing insulation material around the electrode stack.
Figure 12 illustrates a cross-sectional view of one embodiment of the preprocessed wafer and electrode stack after etching an opening through the electrode stack.
Figure 13 illustrates a cross-sectional view of one embodiment of the preprocessed wafer, electrode stack, and a phase-change material in the opening through the electrode stack.
Figure 14 illustrates a cross-sectional view of one embodiment of the preprocessed wafer, electrode stack, phase-change material, and a second electrode.

### Detailed Description

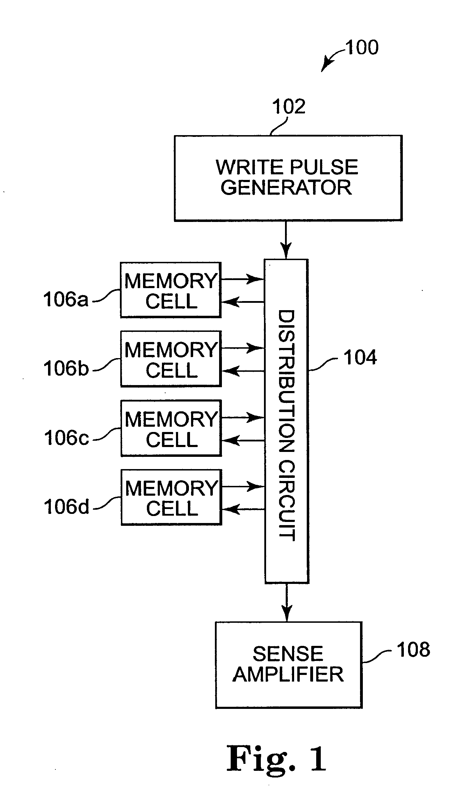

Figure 1 illustrates a block diagram of one embodiment of a memory cell device 100. Memory cell device 100 includes a write pulse generator 102, a distribution circuit 104, memory cells 106a, 106b, 106c, and 106d, and a sense amplifier 108. In one embodiment, memory cells 106a-106d are phase-change memory cells that are based on the amorphous to crystalline phase transition of the memory material.

Each phase-change memory cell 106a-106d includes phase-change material defining a storage location. The phase-change material is coupled to a first electrode through a first ring contact and to a second electrode through a second ring contact. The first ring contact and the second ring contact are formed by depositions of contact material in which the thicknesses of the depositions are controlled. In one embodiment, the first ring contact has a thickness that is approximately equal to a thickness of the second ring contact. In another embodiment, the first ring contact has a thickness that is different than a thickness of the second ring contact. A storage location is formed by etching a via through the two planar depositions of contact material and depositing phase-change material in the via.

The memory cell is easy to fabricate and may decrease the contact area and phase-change volume of the memory cell as compared to typical phase-change memory cells. This results in lower set and particularly reset currents and powers. The contact areas defined by the thicknesses of the deposited contact material layers can be adjusted with great precision so that the memory cell to memory cell variations are easier to control than for example a heater type phase-change memory cell. By adjusting the thickness of a dielectric layer between the contact material layers, the memory cell resistance can be finely adjusted to optimize the memory cell current and/or power, depending on the specific application.

In one embodiment, write pulse generator 102 generates current or voltage pulses that are controllably directed to memory cells 106a-106d via distribution circuit 104. In one embodiment, distribution circuit 104 includes a plurality of transistors that controllably direct current or voltage pulses to the memory cells.

In one embodiment, memory cells 106a-106d are made of a phase-change material that may be changed from an amorphous state to a crystalline state or from a crystalline state to an amorphous state under influence of temperature change. The degree of crystallinity thereby defines at least two memory states for storing data within memory cell device 100. The at least two memory states can be assigned to the bit values "0" and "1". The bit states of memory cells 106a-106d differ significantly in their electrical resistivity. In the amorphous state, a phase-change material exhibits significantly higher resistivity than in the crystalline state. In this way, sense amplifier 108 reads the cell resistance such that the bit value assigned to a particular memory cell 106a-106d is determined.

To program a memory cell 106a-106d within memory cell device 100, write pulse generator 102 generates a current or voltage pulse for heating the phase-change material in the target memory cell. In one embodiment, write pulse generator 102 generates an appropriate current or voltage pulse, which is fed into distribution circuit 104 and distributed to the appropriate target memory cell 106a-106d. The current or voltage pulse amplitude and duration is controlled depending on whether the memory cell is being set or reset. Generally, a "set" operation of a memory cell is heating the phase-change material of the target memory cell above its crystallization temperature (but below its melting temperature) long enough to achieve the crystalline state. Generally, a "reset" operation of a memory cell is heating the phase-change material of the target memory cell above its melting temperature, and then quickly quench cooling the material, thereby achieving the amorphous state.

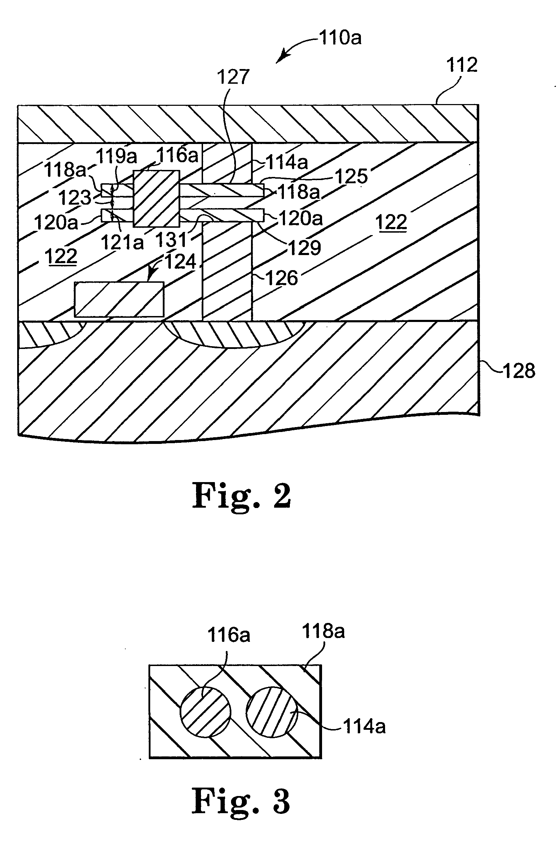

Figure 2 illustrates a cross-sectional view of one embodiment of a phase-change memory cell 110a. Phase-change memory cell 110a includes a selection device 124, a first electrode 126, a first contact 120a, phase-change material 116a, a second contact 118a, a second electrode 114a, and higher metallization layer 112. Phase-change material 116a is laterally completely enclosed by insulation material 122, which defines the current path and hence the location of the phase-change region in phase-change material 116a. Phase-change material 116a provides a storage location for storing one bit or several bits of data. Selection device 124, such as an active device like a transistor 124 or a diode, is coupled to first electrode 126 to control the application of current or voltage to first electrode 126, and thus to contact 120a and phase-change material 116a, to set and reset phase-change material 116a.

Phase-change material 116a is in contact with first ring contact 120a and second ring contact 120a. First ring contact 120a has a thickness 121a, and second ring contact 118a has a thickness 119a. In one embodiment, thickness 121a of first ring contact 120a is approximately equal to thickness 119a of second ring contact 118a. An advantage of the double ring contact memory cell structure is that the contact area is defined by the thicknesses 121 a and 119a of the deposited contact material layers that form first ring contact 120a and second ring contact 118a. The thicknesses 121a and 119a of the deposited contact material layers can be adjusted with great precision so that the memory cell to memory cell variations are easier to control than in for example a heater type phase-change memory cell. By adjusting the thickness 123 of the insulation material 122 between first ring contact 120a and second ring contact 118a, the memory cell resistance and the switched volume can be finely adjusted to optimize the memory cell current and/or power.

Phase-change material 116a may be made up of a variety of materials in accordance with the present invention. Generally, chalcogenide alloys that contain one or more elements from column IV of the periodic table are useful as such materials. In one embodiment, phase-change material 116a of memory cell 110a is made up of a chalcogenide compound material, such as GeSbTe or AgInSbTe. In another embodiment, the phase-change material can be chalcogen free such as GeSb, GaSb, SbTe, or GeGaSb.

During a set operation of phase-change memory cell 110a, a set current or voltage pulse is selectively enabled to selection device 124 and sent through first electrode 126 and contact 120a to phase-change material 116a thereby heating it above its crystallization temperature (but usually below its melting temperature). In this way, phase-change material 116a reaches its crystalline state during this set operation. During a reset operation of phase-change memory cell 110a, a reset current and/or voltage pulse is selectively enabled to selection device 124 and sent through first electrode 126 and contact 120a to phase-change material 116a. The reset current or voltage quickly heats phase-change material 116a above its melting temperature. After the current and/or voltage pulse is turned off, phase-change material 116a quickly quench cools into the amorphous state.

Figure 3 illustrates a top cross-sectional view of ring contact 118a, phase-change material 116a, and second electrode 114a. In one embodiment, phase-change material 116a and second electrode 114a are cylindrical in shape. In another embodiment, phase-change material 116a and second electrode 114a are other suitable shapes, such as elliptical, square, or rectangular. In one embodiment, ring contact 118a encircles both phase-change material 116a and second electrode 114a. In another embodiment, ring contact 118a encircles phase-change material 116a, and the upper planar surface 125 (Fig. 2) of ring contact 118a contacts the lower planar surface 127 of second electrode 114a. First ring contact 120a encircles phase-change material 116a, and the lower planar surface 129 (Fig. 2) of ring contact 120a contacts the upper planar surface 131 of first electrode 126.

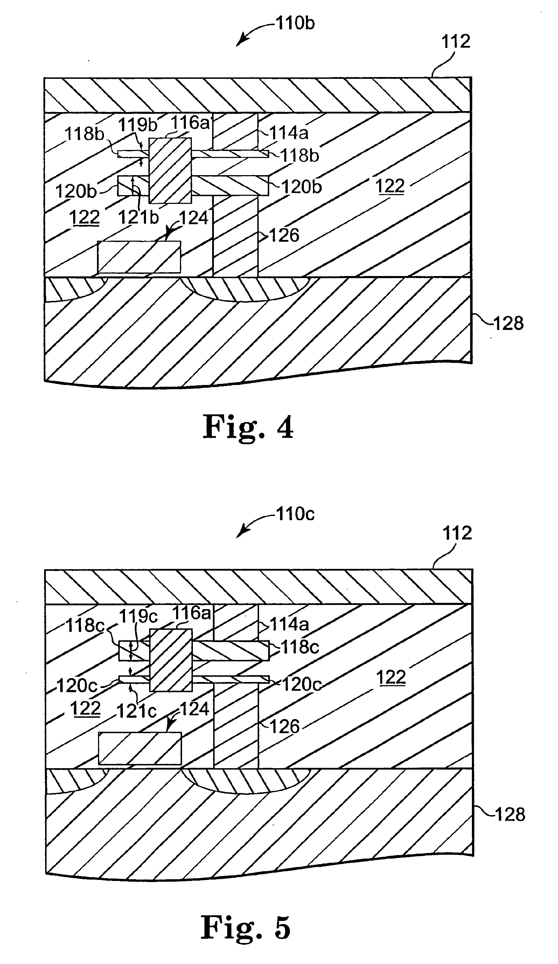

Figure 4 illustrates a cross-sectional view of another embodiment of a phase-change memory cell 110b. Phase-change memory cell 110b is similar to phase-change memory cell 110a except that thickness 119b of second ring contact 118b is less than thickness 121b of first ring contact 120b. In one embodiment, thickness 119b of second ring contact 118b is approximately one half of thickness 121b of first ring contact 120b. In other embodiments, other ratios of thickness 119b of second ring contact 118b to thickness 121b of first ring contact 120b are used.

Figure 5 illustrates a cross-sectional view of another embodiment of a phase-change memory cell 110c. Phase-change memory cell 110c is similar to phase-change memory cell 110a except that thickness 119c of second ring contact 118c is greater than thickness 121 c of first ring contact 120c. In one embodiment, thickness 119c of second ring contact 118c is two times the thickness 121c of first ring contact 120c. In other embodiments, other ratios of thickness 119c of second ring contact 118c to thickness 121c of first ring contact 120c are used. By adjusting the geometry and ring contact thickness relative to the separation between the two ring contacts, the shape and position of the phase-change region can be tuned.

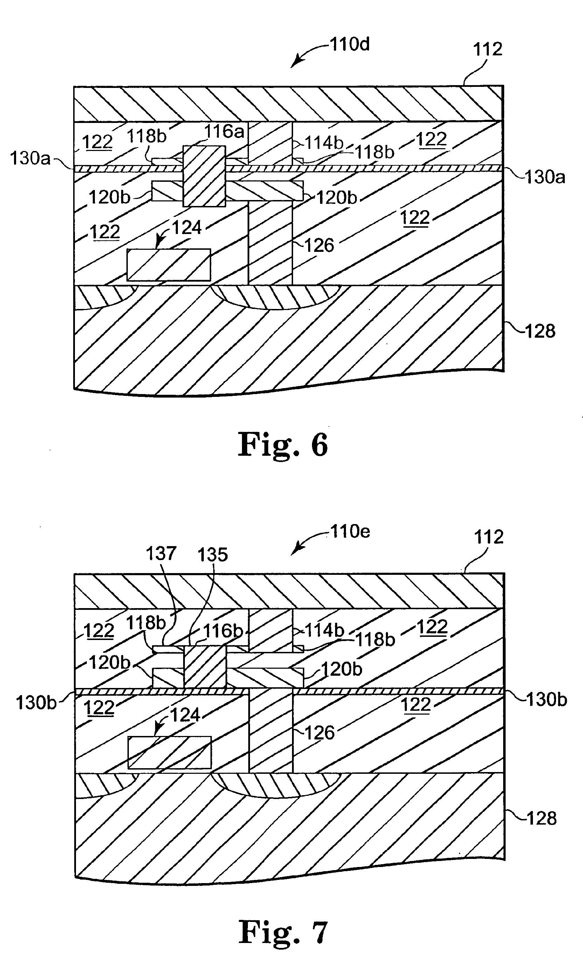

Figure 6 illustrates a cross-sectional view of another embodiment of a phase-change memory cell 110d. Phase-change memory cell 110d is similar to phase-change memory cell 110b except an etch stop layer 130a is added directly underneath second ring contact 118b. A deposition of SiN or other suitable etch stop material provides etch stop layer 130a. Etch stop layer 130a is used to stop the etch process used to form the opening in which electrode material is deposited for forming second electrode 114b. Therefore, second electrode 114b extends through second ring contact 118b to etch stop layer 130a. In another embodiment, an etch stop layer is added directly on top of second ring contact 118b. In this embodiment, the etch stop layer is used to stop the etch used to form the opening in which electrode material is deposited for forming second electrode 114b. A breakthrough etch through the etch stop layer is used in the opening to expose second ring contact 118b. Electrode material is then deposited in the opening to form second electrode 114b.

Figure 7 illustrates a cross-sectional view of another embodiment of a phase-change memory cell 110e. Phase-change memory cell 110e is similar to phase-change memory cell 110b except an etch stop layer 130b is added directly underneath and contacting first ring contact 120b. A deposition of SiN or other suitable etch stop material provides etch stop layer 130b. Etch stop layer 130b is used to stop the etch used to form the opening in which phase-change material 116b is deposited. Therefore, phase-change material 116b stops at etch stop layer 130b so that the bottom portion 133 of phase-change material 116b is coplanar with the bottom portion 129 of first ring contact 120b. In one embodiment, top surface 135 of phase-change material 116b is coplanar with the top surface 137 of second ring contact 118b. In one embodiment, the coplanar surfaces of phase-change material 116b and second ring contact 118b are formed using chemical mechanical planarization (CMP) or another suitable planarization process.

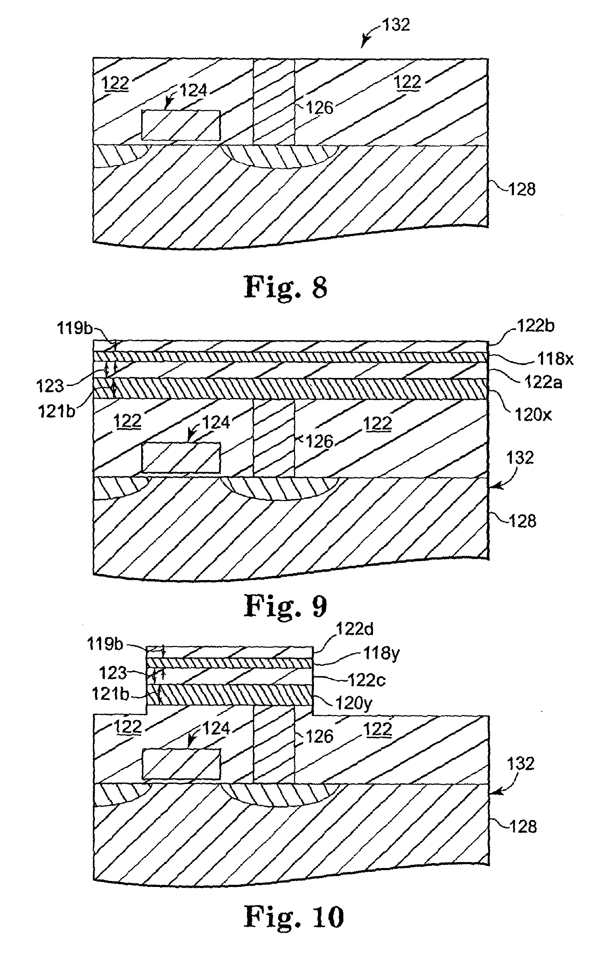

The following Figures 8-14 illustrate embodiments of a process for fabricating phase-change memory cell 110b. A similar process is used for fabricating phase-change memory cells 110a, 110c, 110d, and 110e.

Figure 8 illustrates a cross-sectional view of one embodiment of a preprocessed wafer 132. Preprocessed wafer 132 includes substrate 128 including a selection device 124, first electrode 126, and insulation material 122. First electrode 126 is a tungsten plug, copper plug, or other suitable electrode. Insulation material 122 is SiO₂, fluorinated silica glass (FSG) or other suitable dielectric material. In one embodiment, selection device 124 is a transistor.

Figure 9 illustrates a cross-sectional view of one embodiment of preprocessed wafer 132 and an electrode stack including a first contact material layer 120x, a first insulation material layer 122a, a second contact material layer 118x, and a second insulation material layer 122b. Contact material, such as TiN, TaN, W, or other suitable contact material, is deposited over preprocessed wafer 132 to provide contact material layer 120x. Contact material layer 120x is deposited at a thickness 121b using chemical vapor deposition (CVD), atomic layer deposition (ALD), metal organic chemical vapor deposition (MOCVD), plasma vapor deposition (PVD), jet vapor deposition (JVP), or other suitable deposition technique. In one embodiment, for fabricating memory cell 110e, an etch stop layer is deposited over preprocessed wafer 132 and etched to expose first electrode 126 before contact material layer 120x is deposited.

Insulation material, such as SiO₂, SiN, FSG, a low k material, or other suitable dielectric material, is deposited over first contact material layer 120x to provide insulation material layer 122a. Insulation material layer 122a is deposited at a thickness 123 using CVD, ALD, MOCVD, PVD, JVP, or other suitable deposition technique.

Contact material, such as TiN, TaN, W, or other suitable contact material, is deposited over first insulation material layer 122a to provide second contact material layer 118x. Contact material layer 118x is deposited at a thickness 119b using CVD, ALD, MOCVD, PVD, JVP, or other suitable deposition technique. In one embodiment, for fabricating memory cell 110d, an etch stop layer is deposited over first insulation material layer 122a before contact material layer 118x is deposited.

Insulation material, such as SiO₂, SiN, FSG, a low k material, or other suitable dielectric material, is deposited over second contact material layer 118x to provide second insulation material layer 122b. Second insulation material layer 122b is deposited using CVD, ALD, MOCVD, PVD, JVP, or other suitable deposition technique.

Figure 10 illustrates a cross-sectional view of one embodiment of preprocessed wafer 132 and the electrode stack including first contact material layer 120y, first insulation material layer 122c, second contact material layer 118y, and second insulation material layer 122d after etching first contact material layer 120x, first insulation material layer 122a, second contact material layer 118x, and second insulation material layer 122b. The electrode stack is etched to define a memory cell location.

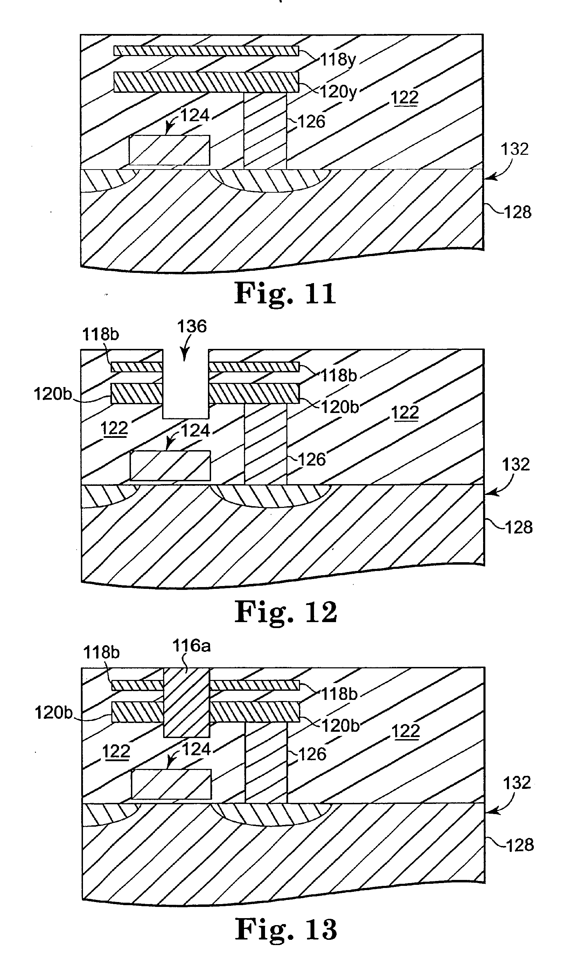

Figure 11 illustrates a cross-sectional view of one embodiment of preprocessed wafer 132 and the electrode stack including first contact material layer 120y and second contact material layer 118y after depositing insulation material 122 around the electrode stack. Insulation material 122 is deposited around first contact material layer 120y, first insulation material layer 122c, second contact material layer 118y, and second insulation material layer 122d using CVD, ALD, MOCVD, PVD, JVP, or other suitable deposition technique. In one embodiment, after the deposition of insulation material 122, insulation material 122 is planarized using CMP or another suitable planarization process.

Figure 12 illustrates a cross-sectional view of one embodiment of preprocessed wafer 132 and the electrode stack including first contact material layer 120b and second contact material layer 118b after etching an opening 136 through second contact material layer 118y and first contact material layer 120y. Insulation material 122, second contact material layer 118y, and first contact material layer 120y are etched to provide second contact material layer 118b and first contact material layer 120b. In one embodiment, a cylindrical via 136 is etched through second contact material layer 118y and first contact material layer 120y to form opening 136.

Figure 13 illustrates a cross-sectional view of one embodiment of preprocessed wafer 132, the electrode stack including first contact material layer 120b and second contact material layer 118b, and phase-change material 116a. Phase-change material 116a, such as a chalcogenic compound or other suitable phase-change material, is deposited in opening 136 by CVD, ALD, MOCVD, PVD, JVP, or other suitable deposition technique. In one embodiment, phase-change material 116a and insulation material 122 are planarized using CMP or another suitable planarization process.

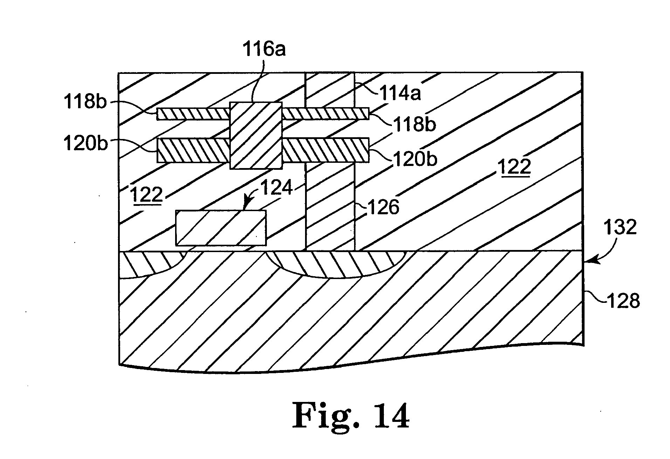

Figure 14 illustrates a cross-sectional view of one embodiment of preprocessed wafer 132, first ring contact 120b, second ring contact 118b, phase-change material 116a, and a second electrode 114a. Insulation material 122 is etched to form an opening to expose ring contact 118b. Electrode material, such as TiN, TaN, W, Al, Cu, or other suitable electrode material, is deposited in the opening to form second electrode 114a. The electrode material is deposited using CVD, ALD, MOCVD, PVD, JVP, or other suitable deposition technique. In one embodiment, second electrode 114a and insulation material 122 are planarized using CMP or another suitable planarization process. Higher metalization layer 112 is then deposited on electrode 114a and insulation material 122 to form memory cell 110b as illustrated in Figure 4.

Embodiments of the present invention provide a double ring contact memory cell. The thickness of each ring contact is controlled by setting the deposition thickness of the contact material. Controlling the cross-section of the electrical contacts to the phase-change material and the thickness of the insulation material between the ring contacts enables optimization of the memory cell current and/or power consumption. The thickness of each of the ring contacts and the thickness of the insulation material between the ring contacts can vary based on the desired characteristics for the memory cell.

## Claims

1. A memory cell comprising:
a first ring contact;
a second ring contact; and
phase-change material contacting the first ring contact and the second ring contact.

2. The memory cell of claim 1, wherein a thickness of the first ring contact is approximately equal to a thickness of the second ring contact.

3. The memory cell of claim 1, wherein a thickness of the first ring contact is different than a thickness of the second ring contact.

4. The memory cell of claim 1, further comprising:
a first electrode contacting the first ring contact; and
a second electrode contacting the second ring contact.

5. The memory cell of claim 3, wherein the phase-change material comprises a chalcogenide.

6. A memory cell comprising:
a first ring contact;
a second ring contact;
phase-change material contacting the first ring contact and the second ring contact; and
an etch stop layer adjacent the second ring contact for stopping an etch for defining an electrode location.

7. The memory cell of claim 6, wherein a thickness of the first ring contact is approximately equal to a thickness of the second ring contact.

8. The memory cell of claim 6, wherein a thickness of the first ring contact is different than a thickness of the second ring contact.

9. The memory cell of claim 6, further comprising:
a first electrode contacting the first ring contact; and
a second electrode contacting the second ring contact.

10. The memory cell of claim 6, wherein the phase-change material comprises a chalcogenide.

11. A memory cell comprising:
a first ring contact;
a second ring contact;
phase-change material contacting the first ring contact and the second ring contact; and
an etch stop layer adjacent the first ring contact for stopping an etch for defining a location of the phase-change material.

12. The memory cell of claim 11, wherein a thickness of the first ring contact is approximately equal to a thickness of the second ring contact.

13. The memory cell of claim 11, wherein a thickness of the first ring contact is different than a thickness of the second ring contact.

14. The memory cell of claim 11, further comprising:
a first electrode contacting the first ring contact; and
a second electrode contacting the second ring contact.

15. The memory cell of claim 11, wherein the phase-change material comprises a chalcogenide.

16. A memory cell comprising:
a first electrode;
a second electrode;
phase-change material spaced apart from the first electrode and the second electrode and parallel to the first electrode and the second electrode;
means for coupling the first electrode to the phase-change material; and
means for coupling the second electrode to the phase-change material.

17. The memory cell of claim 16, wherein the phase-change material comprises a chalcogenide.

18. The memory cell of claim 16, wherein the phase-change material comprises a chalcogen free material.

19. A method for fabricating a memory cell device, the method comprising:
providing a preprocessed wafer having a first electrode;
depositing an electrode stack comprising a first contact material layer over the preprocessed wafer and in contact with the first electrode, a first insulation material layer over the first contact material layer, a second contact material layer over the first insulation material layer, and a second insulation material layer over the second contact material layer;
etching the electrode stack to form a memory cell location;
etching a first opening through the electrode stack;
depositing phase-change material in the first opening to form a first ring contact between the phase-change material and the first contact material layer and a second ring contact between the phase-change material and the second contact material layer; and
fabricating a second electrode in contact with the second contact material layer.

20. The method of claim 19, wherein fabricating the second electrode comprises:
depositing insulation material over the phase-change material and second insulation material layer;
etching the insulation material to form a second opening exposing a portion of the second contact material layer; and
depositing electrode material in the second opening to form the second electrode.

21. The method of claim 19, wherein depositing the electrode stack comprises depositing the first contact material layer at a first thickness and the second contact material layer at a second thickness approximately equal to the first thickness.

22. The method of claim 19, wherein depositing the electrode stack comprises depositing the first contact material layer at a first thickness and the second contact material layer at a second thickness less than the first thickness.

23. The method of claim 19, wherein depositing the electrode stack comprises depositing the first contact material layer at a first thickness and the second contact material layer at a second thickness greater than the first thickness.

24. The method of claim 19, wherein depositing the phase-change material comprises depositing a chalcogenide.

25. A method for fabricating a memory cell device, the method comprising:
providing a preprocessed wafer having a first electrode;
depositing an electrode stack comprising a first contact material layer over the preprocessed wafer and in contact with the first electrode, a first insulation material layer over the first contact material layer, an etch stop material layer over the first insulation material layer, a second contact material layer over the etch stop material layer, and a second insulation material layer over the second contact material layer;
etching the electrode stack to form a memory cell location;
etching a first opening through the electrode stack;
depositing phase-change material in the first opening to form a first ring contact between the phase-change material and the first contact material layer and a second ring contact between the phase-change material and the second contact material layer;
depositing insulation material over the phase-change material and second insulation material layer;
etching a second opening through the insulation material and the second contact material layer to the etch stop material layer; and
depositing electrode material in the second opening to form a second electrode.

26. The method of claim 25, wherein depositing the electrode stack comprises depositing the first contact material layer at a first thickness and the second contact material layer at a second thickness approximately equal to the first thickness.

27. The method of claim 25, wherein depositing the electrode stack comprises depositing the first contact material layer at a first thickness and the second contact material layer at a second thickness less than the first thickness.

28. The method of claim 25, wherein depositing the electrode stack comprises depositing the first contact material layer at a first thickness and the second contact material layer at a second thickness greater than the first thickness.

29. The method of claim 25, wherein depositing the phase-change material comprises depositing a chalcogenide.

30. A method for fabricating a memory cell device, the method comprising:
providing a preprocessed wafer having a first electrode;
depositing an etch stop material layer over the preprocessed wafer;
etching the etch stop material layer to form a first opening to expose the first electrode;
depositing an electrode stack comprising a first contact material layer over the etch stop material layer and the first electrode, a first insulation material layer over the first contact material layer, a second contact material layer over the first insulation material layer, and a second insulation material layer over the second contact material layer;
etching the electrode stack to form a memory cell location;
etching a second opening through the electrode stack to the etch stop material layer;
depositing phase-change material in the second opening to form a first ring contact between the phase-change material and the first contact material layer and a second ring contact between the phase-change material and the second contact material layer; and
fabricating a second electrode in contact with the second contact material layer.

31. The method of claim 30, further comprising:
planarizing the phase-change material and the second insulation material layer to the second contact material layer.

32. The method of claim 30, wherein fabricating the second electrode comprises:
depositing insulation material over the phase-change material and second insulation material layer;
etching the insulation material to form a second opening exposing a portion of the second contact material layer; and
depositing electrode material in the second opening to form the second electrode.

33. The method of claim 30, wherein depositing the electrode stack comprises depositing the first contact material layer at a first thickness and the second contact material layer at a second thickness approximately equal to the first thickness.

34. The method of claim 30, wherein depositing the electrode stack comprises depositing the first contact material layer at a first thickness and the second contact material layer at a second thickness less than the first thickness.

35. The method of claim 30, wherein depositing the electrode stack comprises depositing the first contact material layer at a first thickness and the second contact material layer at a second thickness greater than the first thickness.

36. The method of claim 30, wherein depositing the phase-change material comprises depositing a chalcogenide.

37. A memory device comprising:
a write pulse generator for generating a write pulse signal;
a sense amplifier for sensing a read signal;
a distribution circuit; and
a plurality of phase-change memory cells each capable of defining at least a first state and a second state, each memory cell further comprising a first ring contact, a second ring contact, and phase-change material contacting the first ring contact and the second ring contact.

38. The memory cell of claim 37, wherein a thickness of the first ring contact is approximately equal to a thickness of the second ring contact.

39. The memory cell of claim 37, wherein a thickness of the first ring contact is different than a thickness of the second ring contact.

40. The memory cell of claim 37, wherein each memory cell further comprises a first electrode contacting the first ring contact and a second electrode contacting the second ring contact.

41. The memory cell of claim 37, wherein the phase-change material comprises a chalcogenide.
